# EUROPÄISCHE PATENTSCHRIFT

(11) **EP 3 582 263 B1**
(45) Veröffentlichungstag und Bekanntmachung des Hinweises auf die Patenterteilung: **29.03.2023**
(21) Anmeldenummer: 19179742.2
(22) Anmeldetag: 12.06.2019
(51) Int. Cl.: H01L 25/075, H01L 33/62

(54) **LICHTERZEUGENDE BAUGRUPPE FÜR EINEN SCHEINWERFER SOWIE SCHEINWERFER**
LIGHT GENERATING ASSEMBLY FOR A HEADLIGHT AND HEADLIGHT
MODULE ÉLECTROLUMINESCENT POUR UN PHARE AINSI QUE PHARE

(30) Priorität: 15.06.2018 EP 18178043
(43) Veröffentlichungstag der Anmeldung: 18.12.2019
(73) Patentinhaber: Arnold & Richter Cine Technik GmbH & Co. Betriebs KG, 80807 München (DE)
(72) Erfinder: HENDRICKS, Frank, 88339 Bad Waldsee (DE); SCHUMACHER, Volker, 88339 Bad Waldsee (DE); MELZNER, Erwin, 83112 Frasdorf (DE)
(74) Vertreter: Maikowski & Ninnemann Patentanwälte Partnerschaft mbB

(56) Entgegenhaltungen:
- WO-A1-2018/104146
- WO-A2-2012/140589
- US-A1- 2012 262 076
- US-A1- 2018 286 841

## Beschreibung

### TECHNISCHES GEBIET

Die vorliegende Erfindung betrifft Ausführungsformen einer lichterzeugenden Baugruppe für einen Scheinwerfer zur Beleuchtung einer Film-, Studio-, Bühnen-, Event- und/oder Theaterumgebung. Insbesondere betrifft die vorliegende Erfindung eine lichterzeugende Baugruppe mit einer bestimmten LED-Anordnung. Ferner betrifft die vorliegende Erfindung Ausführungsformen eines Scheinwerfers zur Beleuchtung einer Film-, Studio-, Bühnen-, Event- und/oder Theaterumgebung.

### HINTERGRUND

Für die Beleuchtung einer Film-, Studio-, Bühnen-, Event- und/oder Theaterumgebung werden üblicherweise Scheinwerfer eingesetzt. Mitunter ist es wünschenswert, dass ein eine lichterzeugende Baugruppe umfassender Scheinwerfer einen ausreichenden Lichtstrom bereitstellt und weiteren Anforderungen, wie sie für eine Film-, Studio-, Bühnen-, Event- und/oder Theaterumgebung üblich sind, genügt. Derartige Anforderungen umfassen beispielsweise einen Dauerbetrieb über mehrere Stunden, einen weiten Verstellbereich eines Abstrahlwinkels, ein homogenes und/oder ein weich auslaufendes Lichtfeld. Diese Funktionen müssen auch unter erschwerten Umweltbedingungen und bei starker Beanspruchung des Scheinwerfers zuverlässig bereitgestellt werden.

Anstelle von herkömmlichen Lichtquellen, wie beispielsweise Glühbirnen oder Gasentladungslampen, werden zunehmend lichterzeugende Baugruppen mit einer LED-Anordnung eingesetzt. Dabei können mehrere LEDs auf einem Träger angeordnet werden, und das von diesen LEDs produzierte Licht kann optisch weiterverarbeitet werden, um einen Scheinwerfer mit bestimmten Eigenschaften bereitzustellen.

WO 2018/104146 A1 und US 2012/262076 A1 betreffen eine lichterzeugende Baugruppe mit einem Träger, auf dem eine LED-Anordnung mit einer Vielzahl von LEDs angeordnet ist.

Üblicherweise ist es wünschenswert, eine sehr kompakte, farblich einstellbare Lichtquelle zu bauen. Dies verlangt mitunter, dass LEDs eng benachbart zueinander angeordnet sind. Allerdings kann eine hohe Packungsdichte eine aufwendige Implementierung einer Stromversorgung bedingen, da LEDs verschiedener Farbtypen an unterschiedlichen Positionen mit unterschiedlichen Betriebsströmen versorgt werden müssen. Die weiter aufgrund der Verlustleistung möglicherweise einhergehenden hohen Temperaturen können den Einsatz gut wärmeleitender Substrate verlangen, was jedoch zu Einschränkungen betreffend die Auslegung und Verlegung der Stromleitungen führen kann. Packungsdichte, Kühlung und eine gute Farbmischung wirken also mitunter gegeneinander. Hinzu kommt, dass insbesondere bei relativ kompakten lichterzeugenden Baugruppen hohe Anforderungen an die geometrische Präzision der Optiken zu stellen sind, die das von den LEDs ausgehende Licht weiterverarbeiten. Insbesondere bei sogenannten Linsenarrays kommt es nämlich darauf an, dass die Einzellinsen exakt über den jeweils zugeordneten LEDs positioniert sind. Wegen der hohen Temperaturen in kompakten lichterzeugenden Baugruppen kann es zudem notwendig sein, die Optiken aus Glas herzustellen anstatt aus Kunststoff. Das bedingt eine aufwendige und vergleichsweise teure Herstellung.

Aufgabe der vorliegenden Erfindung ist es daher, eine lichterzeugende Baugruppe sowie einen damit ausgestatteten Scheinwerfer vorzuschlagen, bei denen der oben genannten Zielkonflikt aufgehoben oder zumindest abgemildert ist. Es soll also insbesondere eine lichterzeugende Baugruppe angegeben werden, die ein farblich gut durchmischtes Licht bereitstellen kann und dabei besonders kompakt ausfällt. Gleichzeitig soll die Baugruppe einfach und kostengünstig herstellbar sein. Gleiches gilt für einen damit ausgestatteten Scheinwerfer.

### BESCHREIBUNG

Die Aufgabe wird durch eine lichterzeugende Baugruppe gelöst, mit
- einem Träger, auf dem eine LED-Anordnung mit einer Vielzahl von LEDs angeordnet ist, wobei die LEDs LEDs von N > 2 unterschiedlichen Farbtypen umfassen und von jedem der N Farbtypen eine beliebige Anzahl an LEDs vorgesehen ist, und wobei eine Lötflächenseite einer jeden der LEDs einer Trägervorderseite zugewandt ist, wobei der Träger als einlagige Leiterplatte ausgebildet ist;
- einem Leitungssystem zur Stromversorgung der LEDs, umfassend eine Vielzahl von Leitungen mit N Leitungstypen, wobei sich Leitungen unterschiedlichen Leitungstyps in Kreuzungsbereichen kreuzen und die Kreuzungsbereiche in einer vertikalen Draufsicht auf die Trägervorderseite außerhalb einer vertikalen Projektionsfläche der Lötflächenseiten auf die Trägervorderseite liegen; und
- einer mit der LED-Anordnung gekoppelten Optik, die die Gesamtheit der LEDs überspannt und dazu ausgebildet ist, das von jeder der LEDs ausgehende Licht zu empfangen und zu formen.

Ferner wird die Aufgabe durch eine lichterzeugende Baugruppe gelöst, mit
- einem Träger, auf dem eine LED-Anordnung mit einer Vielzahl von LEDs angeordnet ist, wobei die LEDs LEDs von N>2 unterschiedlichen Farbtypen umfassen und von jedem der N Farbtypen eine beliebige Anzahl an LEDs vorgesehen ist;
- einem Leitungssystem zur Stromversorgung der LEDs, umfassend eine Vielzahl von Leitungen mit N Leitungstypen; und
- einer mit der LED-Anordnung gekoppelten Optik, die die Gesamtheit der LEDs überspannt und dazu ausgebildet ist, das von jeder der LEDs ausgehende Licht zu empfangen und zu formen, und
- wobei der Träger im Bereich einer vertikalen Projektionsfläche der LEDs auf den Träger hinsichtlich der Leitungen einlagig aufgebaut ist.

Solche lichterzeugende Baugruppen können auch als LED-Lichtquelle oder Lightengine bezeichnet werden. Dadurch, dass die Kreuzungsbereiche außerhalb der vertikalen Projektionsflächen der Lötflächenseiten (Footprint-Seite) liegen und/oder der Träger in diesem Bereich einlagig aufgebaut ist, ist eine gute Wärmeleitung zwischen den LEDs und dem Träger gewährleistet. Mit anderen Worten können die LEDs zuverlässig gekühlt werden. Dies ermöglicht einen besonders kompakten Aufbau der lichterzeugenden Baugruppe. Mittels der N Leitungstypen können die LEDs der N Farbtypen farbtypweise einzeln oder in beliebigen Kombinationen geschaltet werden. Die lichterzeugende Baugruppe kann also den N Farbtypen sowie deren Kombinationen entsprechendes Licht bereitstellen. Für den Fall, dass eine Kombination geschaltet ist, ist das von der lichterzeugenden Baugruppe abgegebene Licht zudem besonders gut durchmischt. Indem Kreuzungsbereiche für Leitungen unterschiedlichen Typs vorgesehen sind, können die LEDs in beliebiger Weise auf dem Träger angeordnet werden. Auch dies ist einer guten Lichtdurchmischung zuträglich.

Bei den LEDs handelt es sich beispielsweise um sogenannte linsenfreie LEDs. Die LEDs weisen z.B. außer den zur Lichterzeugung und -abstrahlung strikt notwendigen optischen Komponenten keine weiteren optischen Komponenten auf, die lediglich der Formung oder anderweitigen Beeinflussung des abgestrahlten Lichts dienen. Solche linsenfreien LEDs sind vergleichsweise einfach im Aufbau und kostengünstig am Markt erhältlich. Zudem haben sie kompakte Abmessungen.

Beispielsweise ist die Baugruppe linsenarrayfrei. Das bedeutet, dass die lichterzeugende Baugruppe kein Linsenarray aufweist. Nachdem ein Linsenarray für eine LED-Anordnung eine Vielzahl an Einzellinsen umfasst (z.B. genau eine für jede LED), die im Sinne einer kompakten lichterzeugenden Baugruppe sehr klein sein müssen, limitieren die kleinsten, noch herstellbaren Abmessungen der Linsen eines solchen Linsenarrays die Baugröße der lichterzeugenden Baugruppe in Richtung eines kompakteren Aufbaus. Dies erfolgt einerseits aus technischen Gesichtspunkten, da unterhalb einer gewissen Mindestgröße Linsen mit den gewünschten optischen Eigenschaften nicht mehr herstellbar sind. Andererseits findet die Limitierung auch unter wirtschaftlichen Gesichtspunkten statt, da für kleinere Linsenarrays möglicherweise höhere Herstellungskosten anfallen, z. B. dadurch, dass die Linsen aufwendig nachbearbeitet werden müssen. Durch das Weglassen des Linsenarrays werden somit neue Freiheitsgrade bei der Gestaltung der lichterzeugenden Baugruppe eröffnet, insbesondere wird ermöglicht, die lichterzeugende Baugruppe oder Teile davon besonders kompakt zu gestalten.

Beispielsweise ist der Träger eine Leiterplatte. Leiterplatten haben sich als Träger für Anwendungen wie lichterzeugende Baugruppen bewährt. Zudem bedingen sie Fertigungsschritte für die lichterzeugende Baugruppe, die gut beherrschbar sind und mittels Standard-Maschinen und -Anlagen ausgeführt werden können. Eine lichterzeugende Baugruppe, bei der der Träger eine Leiterplatte ist, kann also einfach und kostengünstig hergestellt werden.

Gemäß einer Ausführungsform ist der Träger als Keramikträger ausgebildet. Weiterhin ist der Träger als eine z.B. vollständig einlagige Leiterplatte (ohne mehrlagige Abschnitte)ausgebildet.

Die sich kreuzenden Leitungen können in einer Richtung vertikal zur Trägervorderseite übereinander verlaufen, wobei eine der sich kreuzenden Leitungen als Bondbrücke, die z.B. oberhalb des Trägers verläuft, ausgebildet sein. Es bestehen also zwei Alternativen, sich kreuzende Leitungen zu realisieren. Im Falle einer Bondbrücke umfasst eine der Leitungen im Kreuzungsbereich einen Drahtabschnitt, der über oder unter der anderen Leitung verläuft. Dies ist eine bewährte und zuverlässige Technik, Leitungskreuzungen zu realisieren.

Für den Fall, dass eine der sich kreuzenden Leitungen als Bondbrücke ausgebildet ist, kann sich diese Bondbrücke auch direkt von einer der LEDs, d.h. von einer Elektrode der LED, zu einer Leiterbahn erstrecken, wobei eine oder mehrere Leiterbahnen oder auch LEDs überbrückt werden können. Ebenso ist es denkbar, dass sich die Bondbrücke von einer Kante oder Ecke einer LED zu einer Leiterbahn, die sich an der gegenüberliegenden Kante oder Ecke befindet erstreckt. Es wird also die LED überbrückt. Auch kann sich eine Bondbrücke von einer der LEDs zu einer anderen der LEDs erstrecken.

Bei einer Ausführungsform sind alle LEDs gemäß einem regelmäßigen Raster auf der Trägervorderseite angeordnet, wonach:
- auf der Trägervorderseite eine Vielzahl von zueinander überlappungsfrei und in einem Querabstand angeordneten Rasterbahnen vorgesehen ist;
- jede Rasterbahn eine Vielzahl von Rasterstellplätzen umfasst, auf der jeweils eine LED positionierbar ist, wobei die Rasterstellplätze einzeln hintereinander entlang einer fiktiven Verlaufsbahn vom Rasterbahneingang zum Rasterbahnausgang angeordnet sind; und
- in jeder von mindestens 90% aller Rasterbahnen mindestens eine LED von jedem der N unterschiedlichen Farbtypen vorgesehen ist, wobei die LEDs innerhalb der Rasterbahnen in beliebiger Reihenfolge angeordnet sind.

Die LEDs sind z.B. sowohl innerhalb der mindestens 90% der Rasterbahnen als auch innerhalb der LED-Anordnung als Ganzes in beliebiger Weise anordenbar. Dies gewährleistet eine gute Farbdurchmischung. Zudem wird so sichergestellt, dass lichterzeugende Baugruppen für unterschiedlichste Bedürfnisse und Anwendungen bereitgestellt werden können, indem keinerlei Restriktionen hinsichtlich der Farbtypen der LEDs vorliegen.

Der Träger kann, wie gesagt, als Keramikträger ausgebildet sein.

Das Leitungssystem umfasst beispielsweise Leiterbahnen. Die Leiterbahnen sind gemäß einer Ausführungsform zumindest teilweise auf dem Träger angebracht. Die Leiterbahnen des Leitungssystems können nach einer anderen Ausführungsform ausschließlich auf dem Träger angebracht sein. Zum Beispiel sind die Leiterbahnen zumindest teilweise auf dem Träger auflaminiert.

Gemäß einer Ausführungsform der lichterzeugenden Baugruppe ist der Träger als Keramikträger ausgebildet und das Leitungssystem umfasst zur Stromversorgung der LEDs die Vielzahl von als Leiterbahnen ausgebildete Leitungen, die auf dem Keramikträger auflaminiert sind oder in sonstiger Weise am Keramikträger befestigt sind.

Gemäß einer Ausführungsform der lichterzeugenden Baugruppe ist der Träger als Leiterplatte (z.B. als PCB Leiterplatte) ausgebildet und das Leitungssystem umfasst zur Stromversorgung der LEDs die Vielzahl von als Leiterbahnen ausgebildete Leitungen, die zumindest teilweise in die Leiterplatte eingelassen sind oder in sonstiger Weise an der Leiterplatte befestigt sind. Zum Beispiel ist der Träger als einlagige Leiterplatte ausgebildet.

Gemäß einer Ausführungsform umfasst das Leitungssystem Hauptleiterbahnen, die entlang der fiktiven Verlaufsbahn der Rasterbahn verlaufen sowie untereinander und mit den Rasterbahnen überlappungsfrei sind, wobei zwischen zwei benachbarten Rasterbahnen höchstens N Hauptleiterbahnen vorliegen, und die Hauptleiterbahnen jeweils unterschiedlichen Farbtypen zugeordnet sind. Bei einer solchen Anordnung der Hauptleiterbahnen verlaufen also in jedem Zwischenraum zwischen zwei Rasterbahnen Hauptleiterbahnen, die allen vorhandenen Farbtypen zugeordnet sind. Es lassen sich so LEDs von N unterschiedlichen Farbtypen, die in beliebiger Weise auf dem Träger angeordnet sind, über das Leitungssystem versorgen.

Auch kann das Leitungssystem Hauptleiterbahnen umfassen, die entlang der fiktiven Verlaufsbahn der Rasterbahn verlaufen sowie untereinander und mit den Rasterbahnen überlappungsfrei sind, wobei zwischen zwei benachbarten Rasterbahnen höchstens 0,5 x N Hauptleiterbahnen vorliegen (wobei 0,5 x N auf die nächsthöhere Ganzzahl aufgerundet ist, falls N ungerade ist), und die Hauptleiterbahnen, die in einer Richtung quer zur fiktiven Verlaufsbahn einer Rasterbahn beiderseits benachbart sind, jeweils unterschiedlichen Farbtypen zugeordnet sind. Es sind also die Hauptleiterbahnen zwischen einer Rasterbahn und einer dieser auf einer ersten Seite benachbarten Rasterbahn anderen Farbtypen zugeordnet als die Hauptleiterbahnen zwischen der Rasterbahn und einer dieser auf einer zweiten, der ersten entgegengesetzten Seite benachbarten Rasterbahn. Bei vier Farbtypen verlaufen somit in jedem Zwischenraum nur zwei Hauptleiterbahnen, die jeweils unterschiedlichen Farbtypen zugeordnet sind. Es verlaufen also beispielsweise auf der ersten Seite eine Hauptleiterbahn, die dem Farbtyp rot zugeordnet ist, sowie eine Hauptleiterbahn, die dem Farbtyp gelb zugeordnet ist. Auf der zweiten Seite verlaufen eine Hauptleiterbahn, die dem Farbtyp weiß zugeordnet ist, sowie eine Hauptleiterbahn, die dem Farbtyp grün zugeordnet ist. In jedem Zwischenraum verlaufen also bei insgesamt vier Farbtypen lediglich Hauptleiterbahnen, die zwei Farbtypen zugeordnet sind. Anders gesagt, sind die vorgenannten Rasterbahnen um 0,5 x N Hauptleiterbahnbreiten voneinander beabstandet, wenn die Abstände zwischen den Hauptleiterbahnen sowie zwischen den Hauptleiterbahnen und den Rasterbahnen vernachlässigt werden. Es ergibt sich so ein besonders kompakter Aufbau der lichterzeugenden Baugruppe.

In einer Variante sind N = 4 Farbtypen vorgesehen und zwischen zwei benachbarten Rasterbahnen liegen jeweils zwei Hauptleiterbahnen vor, wobei die Hauptleiterbahnen, die in einer Richtung quer zur fiktiven Verlaufsbahn einer Rasterbahn beiderseits benachbart sind, jeweils unterschiedlichen Farbtypen zugeordnet sind. Die bereits genannten Vorteile und Effekte ergeben sich analog.

Beispielsweise verlaufen die Hauptleiterbahnen kreuzungsfrei. Die Hauptleiterbahnen können somit besonders einfach am Träger angeordnet werden. Dadurch wird eine einfache und kostengünstige Herstellbarkeit der lichterzeugenden Baugruppe gewährleistet.

Eine Gestaltungsalternative sieht vor, dass jede der LEDs in einer Richtung quer zur Verlaufsbahn der Rasterbahn mittels zweier Anschlussbahnen mit der hinsichtlich des Farbtyps zugeordneten Hauptleiterbahn elektrisch verbunden ist. Über solche Anschlussbahnen lassen sich die LEDs gemäß einer Ausführungsform mit Strom versorgen.

Dabei können zwischen zwei entlang der Verlaufsbahn benachbarten Rasterstellplätzen einer Rasterbahn höchstens zwei Anschlussbahnen verlaufen, wobei den Anschlussbahnen jeweils derjenige Farbtyp zugeordnet ist, der der entlang der Verlaufsbahn an diese angrenzenden LED entspricht. Entlang der Verlaufsbahn sind (unabhängig von der Anzahl der Farbtypen innerhalb der Verlaufsbahn) zwei benachbarte Rasterstellplätze also lediglich um diejenige Breite beabstandet, die für zwei Anschlussbahnen notwendig ist. Die einzelnen Rasterstellplätze sind also in Richtung der Verlaufsbahnen vergleichsweise dicht aneinander angeordnet, wodurch sich ein kompakter Aufbau der lichterzeugenden Baugruppe ergibt.

Die Anschlussbahnen können jeweils mit einem Kontaktabschnitt der zugeordneten LED elektrisch verbunden sein und die Kontaktabschnitte können sich entlang der Verlaufsbahn erstrecken.

Ferner kann jeder der Kreuzungsbereiche durch eine Anschlussbahn und eine Hauptleiterbahn gebildet sein, die unterschiedlichen Farbtypen zugeordnet sind, wobei die den Kreuzungsbereich bildende Hauptleiterbahn benachbart zu einer Hauptleiterbahn angeordnet ist, mit der die den Kreuzungsbereich bildende Anschlussbahn elektrisch verbunden ist. Mit anderen Worten über- oder unterqueren also die Anschlussbahnen diejenige Hauptleiterbahn, die zwischen der mit der Anschlussbahn zu verbindenden Hauptleiterbahn und dem zur Anschlussbahn gehörenden Kontaktabschnitt liegt. Vorzugsweise über- oder unterquert dabei jede Anschlussbahn nur eine einzige Hauptleiterbahn. Dadurch ist der Aufbau einer zugehörenden lichterzeugenden Baugruppe kompakt.

Zum Beispiel ist die Optik als ein kegelförmiger oder mehreckförmiger Reflektor, z.B. als ein Reflektor mit hexagonaler Querschnittsfläche ausgebildet. Der Reflektor kann z.B. auf seiner Lichteintritts- und/oder Außenseite entweder rund bzw. ellipsenförmig oder eckig sein. Die Lichteintritts- und Austrittsseite können unterschiedliche Durchmesser (Umkreise) haben, und so kann beispielsweise ein Reflektor in der Form eines abgeschnittenen Kegels oder einer abgeschnittenen Pyramide entstehen.

Bei einer Ausführungsform ist die Optik eine singuläre Kollimationsoptik. Im Unterschied zu einem Linsenarray, das eine Vielzahl an Linsen umfasst, ist erfindungsgemäß also nur eine einzige Kollimationsoptik vorgesehen. Es wird unter einer singulären Kollimationsoptik somit insbesondere kein Linsenarray verstanden. Eine singuläre Kollimationsoptik stellt dabei im Wesentlichen eine einzige Baueinheit dar, wodurch der Aufbau der lichterzeugenden Baugruppe einfach ist. Außerdem bietet eine singuläre Kollimationsoptik den Vorteil, dass sie nicht auf einzelne der LEDs abgestimmt werden muss. Dadurch werden fertigungstechnische Beschränkungen, z. B. minimal mögliche Radien oder Längen, wie sie unter anderem bei Linsenarrays bestehen, wirkungsvoll umgangen. Eine singuläre Kollimationsoptik trägt also auch zu einem kompakten Aufbau der lichterzeugenden Baugruppe bei.

Bei der singulären Kollimationsoptik kann es sich um eine Kollimationslinse handeln.

Gemäß einer anderen Variante ist die Kollimationsoptik ein Kollimationsreflektor, der eine Lichteintrittsöffnung sowie eine Lichtaustrittsöffnung aufweist, die über einen rohrförmigen Lichtleitabschnitt verbunden sind, wobei eine Innenseite des Lichtleitabschnitts reflektierend ist. In diesem Zusammenhang sind zwei Varianten denkbar. Gemäß einer ersten Variante schließt die Lichtaustrittsöffnung einen größeren Flächeninhalt ein als die Lichteintrittsöffnung. Der Kollimationsreflektor weitet sich also in der Lichtabstrahlrichtung. Der Kollimationsreflektor kann beispielsweise aus einem Blech, insbesondere einem sogenannten MIRO-Blech, oder aus Kunststoff hergestellt sein. Im Falle eines Kollimationsreflektors aus Kunststoff ist dieser bevorzugt ein Spritzgussteil mit einer hochreflektierenden Beschichtung auf der Innenseite. Ein solcher Kollimationsreflektor hat drei optische Effekte. Zum einen durchmischt er das von LEDs unterschiedlicher Farbtypen ausgehende Licht in zuverlässiger und wirkungsvoller Weise. Es wird also durch die lichterzeugende Baugruppe farblich gut durchmischtes Licht bereitgestellt, obwohl die einzelnen LEDs in beliebiger Weise auf dem Träger positioniert werden können. Zum anderen werden die von den LEDs ausgehenden Lichtstrahlen durch den Kollimationsreflektor gebündelt. Damit wird der Abstrahlwinkel der LED-Anordnung reduziert. Weiterhin wird auf das seitlich aus den LEDs austretende Licht gesammelt, farblich durchmischt und gebündelt, sodass sich eine große Lichtausbeute ergibt, wenn sich die Eintrittsöffnung des Reflektors auf oder nahe der Leiterplattenoberfläche (Trägervorderseite) befindet. In einer zweiten Variante schließen die Lichtaustrittsöffnung und die Lichteintrittsöffnung im Wesentlichen Flächeninhalte von gleicher Größe ein. Der Lichtleitabschnitt und der Kollimationsreflektor insgesamt können bei dieser Variante als gerade bezeichnet werden. Er kann beispielsweise aus Spiegelglasstreifen zusammengesetzt sein. Alternativ kann er auf die gleiche Weise hergestellt sein wie der Kollimationsreflektor gemäß der ersten Variante. Auch mit einem derartigen Kollimationsreflektor kann eine zuverlässige Durchmischung des von den LEDs ausgehenden Lichts unterschiedlicher Farben erreicht werden. Wenn der Kollimationsreflektor gemäß der zweiten Variante die LEDs seitlich umschließt, stellt er auch eine Lichtsammelfunktionalität bereit. Zum Zwecke der Lichtbündelung kann ein solcher gerader Kollimationsreflektor mit einer Linse oder einem Linsensystem ausgestattet sein.

An der Lichtaustrittseite des Kollimationsreflektors kann zudem eine Schutzvorrichtung, insbesondere ein Schutzglas vorgesehen sein. Eine solche Schutzvorrichtung hindert unerwünschte Partikel, Flüssigkeiten und/oder Gase daran, ins Innere der lichterzeugenden Baugruppe einzudringen. Insbesondere werden die Partikel, Flüssigkeiten und/oder Gase daran gehindert, in den Bereich der LEDs und/oder des Trägers und/oder der Bonddrähte zu gelangen. Somit wird eine lichterzeugende Baugruppe geschaffen, die gegenüber Umwelteinflüssen robust ist und somit einen zuverlässigen Betrieb gewährleistet.

Das Schutzglas ist beispielsweise entspiegelt, d.h. ein- oder beidseitig mit einer Beschichtung versehen, welche die Transmission verbessert und damit die Grenzflächenverluste minimiert.

Alternativ oder zusätzlich zum Schutzglas können auch Linsen oder Streuscheiben als Schutzvorrichtung verwendet werden. In diesem Zusammenhang kann beispielsweise eine Linse an der Lichteintrittsseite oder der Lichtaustrittsseite des Kollimationsreflektors vorgesehen sein. Ebenso sind Kombinationen von Linsen als Schutzvorrichtung einsetzbar. Es kann z. B. an der Lichteintrittsseite des Kollimationsreflektors eine Sammellinse angeordnet sein und an der Lichtaustrittsseite eine achromatische Sammellinse.

Gemäß einer Ausführungsform ist die Optik als ein kegelförmiger oder mehreckförmiger Reflektor, z.B. als ein Reflektor mit hexagonaler Querschnittsfläche ausgebildet, und an der Lichtaustrittsseite der Optik ist die als Diffusor, z.B. als stochastischer oder holografischer Diffusor wirkende Schutzvorrichtung vorgesehen. Auch kann bei dieser Ausführungsform der Träger als einlagige Leiterplatte ausgebildet sein.

In einer Aufsicht auf die Trägervorderseite kann eine Einhüllende der Vielzahl von LEDs ein geschlossener Polygonzug, ein Kreis oder ein Oval sein und ein Randbereich der Lichteintrittsöffnung hinsichtlich seiner Form und seiner Größe der Einhüllenden entsprechen. Dabei ist der Polygonzug insbesondere ein Viereck, vorzugsweise ein Rechteck, ein Fünfeck, ein Sechseck oder ein Achteck. Im montierten Zustand der lichterzeugenden Baugruppe ist der Randbereich der Lichteintrittsöffnung dabei derart auf den Träger aufgesetzt, dass er die LEDs umschließt. Somit wird sichergestellt, dass das von den LEDs emittierte Licht im Wesentlichen verlustfrei in den Kollimationsreflektor eingebracht wird. Zudem ist ein solcher Aufbau besonders kompakt.

Der Kollimationsreflektor kann also als polygonal gefalteter Reflektor ausgebildet sein. Auch ist ein Kollimationsreflektor mit polygonaler Lichteintrittsöffnung denkbar, die in eine kreisförmige oder ellipsoide Lichtaustrittsöffnung übergeht oder umgekehrt. Ebenso können Kollimationsreflektoren verwendet werden, bei denen sowohl die Lichteintrittsöffnung als auch die Lichtaustrittsöffnung polygonal sind, jedoch unterschiedliche Eckenzahlen aufweisen. Ferner kann ein kegelstumpfförmiger Kollimationsreflektor verwendet werden.

Alternativen zum Kollimationsreflektor und zur Kollimationslinse umfassen zudem sogenannte Lichtmischeinheiten, die verspiegelte Hohlzylinder, Hohlzylinder mit weißer Innenfläche sowie Glas- oder Kunststoffzylinder mit runder oder polygonaler Mantelfläche und planer oder strukturierter Lichtein- und Lichtaustrittsfläche umfassen können. Auch sind sogenannte Diffusoren oder Streuscheiben denkbar.

Vorzugsweise liegen auf der Trägervorderseite innerhalb der Einhüllenden 4 bis 16, insbesondere 6 bis 12, LEDs je cm² vor. Die LEDs weisen also eine relativ hohe Packungsdichte auf, insbesondere im Vergleich zu bekannten lichterzeugenden Baugruppen. Dadurch wird ein kompakter Aufbau der lichterzeugenden Baugruppe gewährleistet.

Zusätzlich wird die Aufgabe durch einen Scheinwerfer der eingangs genannten Art, mit einer erfindungsgemäßen lichterzeugenden Baugruppe gelöst. Ein solcher Scheinwerfer ist kompakt im Aufbau sowie einfach und kostengünstig herstellbar. Zudem stellt er farblich gut durchmischtes Licht bereit.

### KURZE BESCHREIBUNG DER ZEICHNUNGEN

Die in den Figuren gezeigten Teile sind nicht notwendigerweise maßstabsgetreu; vielmehr liegt die Betonung in dem Darstellen von Prinzipien der Erfindung. Ferner bezeichnen in den Figuren gleich Bezugszeichen einander entsprechende Teile. In den Figuren zeigen:
- Fig. 1: schematisch und exemplarisch einen erfindungsgemäßen Scheinwerfer mit einer erfindungsgemäßen lichterzeugenden Baugruppe gemäß einer oder mehreren Ausführungsformen;
- Fig. 2: schematisch und exemplarisch eine erfindungsgemäße lichterzeugende Baugruppe gemäß einer oder mehreren Ausführungsformen;
- Fig. 3: schematisch und exemplarisch Aspekte einer erfindungsgemäßen lichterzeugenden Baugruppe, wobei N = 3 Farbtypen vorgesehen sind;
- Fig. 4: schematisch und exemplarisch Aspekte noch einer erfindungsgemäßen lichterzeugenden Baugruppe, wobei N = 4 Farbtypen vorgesehen sind; und
- Fig. 5: schematisch und exemplarisch Aspekte einer zusätzlichen erfindungsgemäßen lichterzeugenden Baugruppe, wobei N = 4 Farbtypen vorgesehen sind;
- Fig. 6: schematisch und exemplarisch alternative Verläufe von Bondbrücken einer erfindungsgemäßen lichterzeugenden Baugruppe; und
- Fig. 7: schematisch und exemplarisch Varianten einer erfindungsgemäßen lichterzeugenden Baugruppe, die mit Schutzvorrichtungen ausgestattet sind.

### DETAILLIERTE BESCHREIBUNG

In der folgenden detaillierten Beschreibung wird auf die begleitenden Zeichnungen Bezug genommen, die dazugehören und in denen durch die Veranschaulichung spezifischer Ausführungsformen gezeigt wird, wie die Erfindung in die Praxis umgesetzt werden kann.

In diesem Zusammenhang kann richtungsangebende Terminologie, wie beispielsweise "ober-", "unter-", "rück-", "vorder-", "hinter-", "nachgelagert", "vorgelagert" etc., mit Bezug auf die Ausrichtung der Figuren, die beschrieben werden, verwendet werden. Weiter können Begriffe wie "vor", "nach" oder "hinter" die Anordnung von Bauteilen in Bezug auf die Richtung der Lichtstrahlen bezeichnen. "Nach der Linse" meint beispielsweise ein der Lichtaustrittseite der Linse zugewandtes Gebiet. Da Teile von Ausführungsformen in einer Reihe von unterschiedlichen Ausrichtungen positioniert sein können, kann die richtungsangebende Terminologie zu Zwecken der Veranschaulichung verwendet werden und ist keinesfalls einschränkend. Es wird darauf hingewiesen, dass andere Ausführungsformen angewandt werden können und strukturelle oder logische Veränderungen ausgeführt werden können, ohne vom Schutzumfang der vorliegenden Erfindung abzuweichen. Die folgende detaillierte Beschreibung ist daher nicht in einem einschränkenden Sinn zu verstehen, und der Schutzumfang der vorliegenden Erfindung ist durch die angefügten Ansprüche definiert.

Bezug wird nunmehr im Detail auf verschiedene Ausführungsformen und auf ein oder mehrere Beispiele, die in den Figuren veranschaulicht sind, genommen. Jedes Beispiel wird in erläuternder Art und Weise präsentiert und ist nicht als eine Einschränkung der Erfindung zu deuten. Beispielsweise können veranschaulichte oder als Teil einer Ausführungsform beschriebene Merkmale auf oder im Zusammenhang mit anderen Ausführungsformen angewandt werden, um noch eine weitere Ausführungsform hervorzubringen. Dass die vorliegende Erfindung derartige Modifizierungen und Variationen umfasst, ist beabsichtigt. Die Beispiele werden unter Anwendung einer spezifischen Sprache beschrieben, die nicht als den Schutzumfang der angefügten Ansprüche einschränkend ausgelegt werden sollte. Die Zeichnungen sind keine maßstabgetreue Wiedergabe und dienen lediglich der Veranschaulichung. Zum besseren Verständnis sind, wenn nicht anders angegeben, dieselben Elemente durch dieselben Referenzen in den verschiedenen Zeichnungen gekennzeichnet worden.

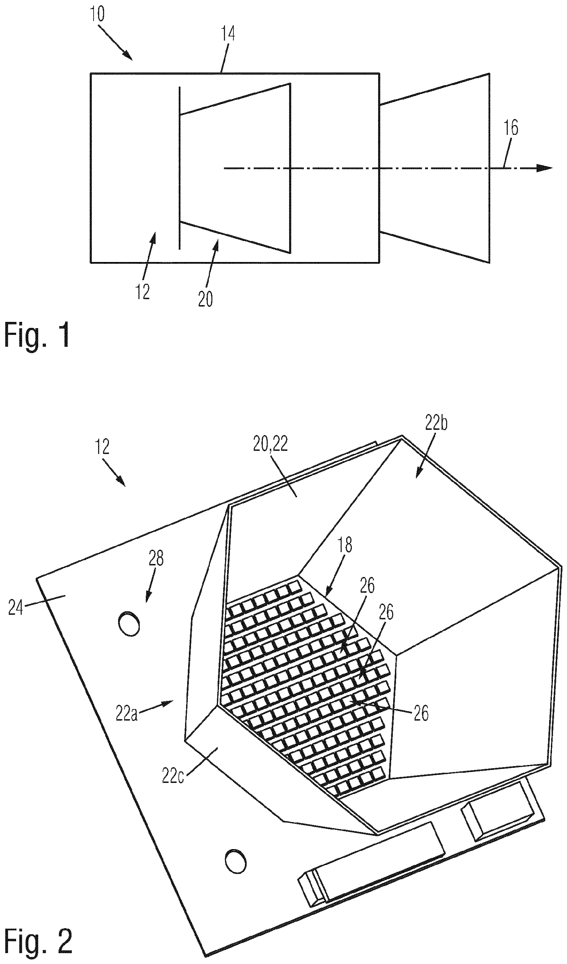

Figur 1 zeigt einen Scheinwerfer 10 mit einer lichterzeugenden Baugruppe 12. Diese ist z.B. im Inneren eines Scheinwerfergehäuses 14 angeordnet.

Der Scheinwerfer 10 kann entlang einer Richtung 16 Licht abstrahlen.

Die lichterzeugende Baugruppe 12 umfasst eine LED-Anordnung 18 (s. Fig. 2) und eine mit der LED-Anordnung 18 gekoppelte Optik 20. Die Optik 20 ist z.B. als ein kegelförmiger oder mehreckförmiger Reflektor, z.B. als ein Reflektor mit hexagonaler Querschnittsfläche ausgebildet ist. Beispielsweise ist die Optik 20 als singuläre Kollimationsoptik in Form eines Kollimationsreflektors 22 ausgebildet.

Die LED-Anordnung 18 weist ferner einen Träger 24 sowie eine Vielzahl LEDs 26 auf, von denen lediglich einige mit einem Bezugszeichen versehen sind.

Die LEDs 26 sind alle auf einer Trägervorderseite 28 des Trägers 24 positioniert. Dabei ist eine Lötflächenseite (Footprint-Seite) der LEDs 26 stets der Trägervorderseite 28 zugewandt.

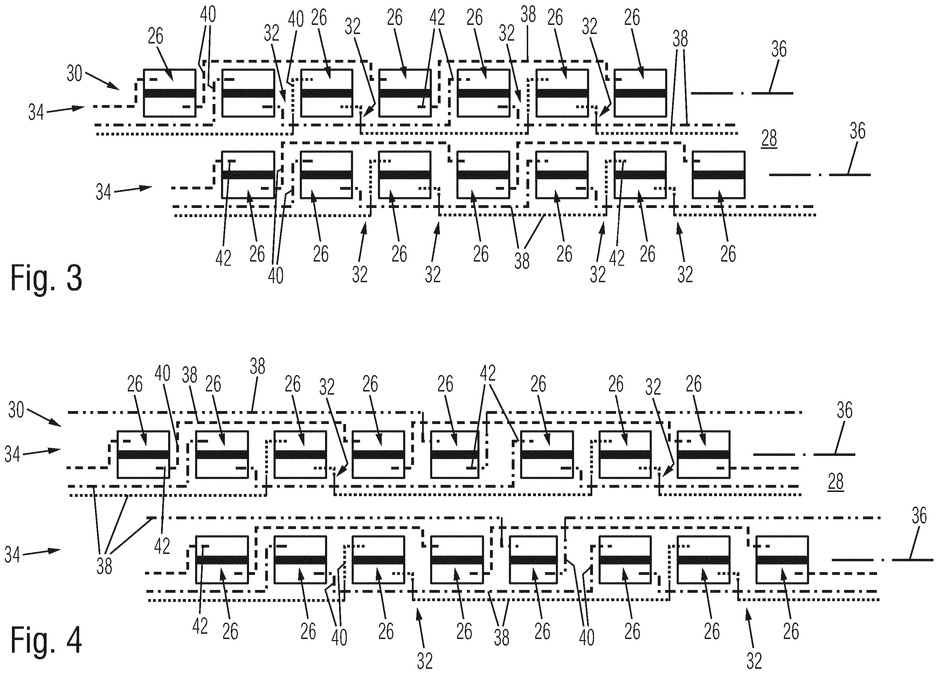

Die LEDs 26 umfassen LEDs von N > 2 unterschiedlichen Farbtypen, wobei von jedem der N Farbtypen eine Vielzahl an LEDs vorgesehen sind (vgl. Figuren 3 bis 5).

N beträgt beispielsweise 4, und die Farbtypen sind weiß, rot, grün, und blau.

In den Ausführungsformen gemäß Figuren 3 bis 5 kreuzen sich Leitungen unterschiedlichen Leitungstyps in Kreuzungsbereichen 32, wobei wieder nur einige der Kreuzungsbereiche 32 mit einem Bezugszeichen versehen sind. Dabei liegen die Kreuzungsbereiche 32 in einer vertikalen Draufsicht auf die Trägervorderseite 28 außerhalb einer vertikalen Projektionsfläche der Lötflächenseiten der LEDs 26 auf die Trägervorderseite 28.

Zudem verlaufen die sich kreuzenden Leitungen in einer Richtung vertikal zur Trägervorderseite 28 übereinander oder untereinander. Dabei sind sie elektrisch gegeneinander isoliert, d.h. nicht verbunden. Der Träger 24 ist einlagig und eine der sich kreuzenden Leitungen als Bondbrücke 33 (z.B. oberhalb und unterhalb des Trägers 24) ausgebildet sein. Zum Beispiel ist der Träger 24 als vollständig einlagige Leiterplatte ausgebildet, und zur Ausbildung der Kreuzungsbereiche werden (anstelle von mehrlagigen Teilabschnitten) Bondbrücken verwendet.

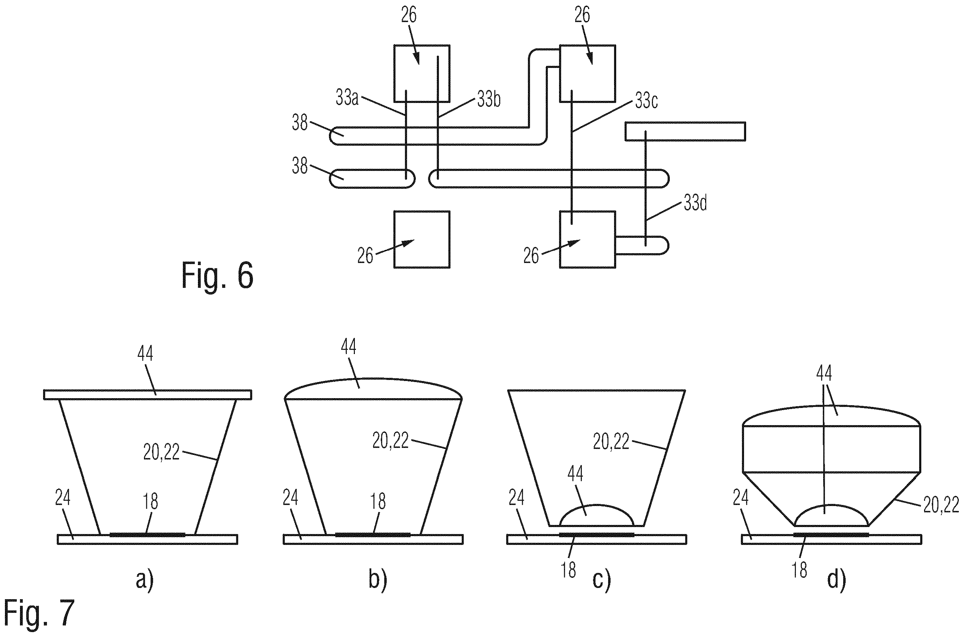

Beispielhafte Ausführungsformen von Bondbrücken 33 sind in Figur 6 dargestellt. Dabei sind die in dieser Figur gezeigten Bondbrücken 33a bis 33d als Alternativen zu verstehen, die in beliebiger Kombination angewendet werden können.

Die Bondbrücke 33a erstreckt sich direkt von einer der LEDs 26 zu einer Hauptleiterbahn 38. Sie überbrückt dabei eine andere Hauptleiterbahn 38.

Die Bondbrücke 33b erstreckt sich von einer Kante oder Ecke einer LED 26 zu einer Hauptleiterbahn 38, die sich an der gegenüberliegenden Kante oder Ecke der LED 26 befindet. Die Bondbrücke 33b überbrückt dabei sowohl die LED 26 als auch eine weitere Hauptleiterbahn 38.

Die Bondbrücke 33c erstreckt sich von einer LED 26 zu einer anderen LED 26. Sie überbrückt dabei eine Hauptleiterbahn 38.

Die Bondbrücke 33d ist beiderseits mit Hauptleiterbahnen 38 verbunden und überbrückt eine weitere Hauptleiterbahn 38.

Wie in den Figuren 3 bis 5 illustriert ist, sind alle LEDs 26 gemäß einem regelmäßigen Raster auf der Trägervorderseite 28 angeordnet. In diesem Zusammenhang sind eine Vielzahl von zueinander überlappungsfrei und in einem Querabstand angeordnete Rasterbahnen 34 vorgesehen. Jede Rasterbahn 34 umfasst dabei eine Vielzahl von Rasterstellplätzen, auf denen jeweils eine LED 26 positionierbar ist. Die Rasterstellplätze sind dabei einzeln hintereinander entlang einer Verlaufsbahn 36 von einem Rasterbahneingang zu einem Rasterbahnausgang angeordnet.

In den dargestellten Ausführungsformen sind alle Rasterstellplätze mit LEDs 26 belegt.

In jeder von mindestens 90% aller Rasterbahnen 34 ist dabei mindestens eine LED 26 von jedem der N unterschiedlichen Farbtypen vorgesehen. Dabei sind die LEDs 26 der unterschiedlichen Farbtypen in beliebiger Reihenfolge positioniert.

Der Wert von mindestens 90% bedeutet dabei, das in praktisch allen Rasterbahnen 34 mindestens je eine LED 26 von jedem der N unterschiedlichen Farbtypen vorgesehen sind. Ausgenommen davon sind beispielsweise Rasterbahnen 34, die am Rand verlaufen oder aufgrund geometrischer Restriktionen nur wenige Rasterstellplätze umfassen.

Entlang der Verlaufsbahn 36 der Rasterbahnen 34 verlaufend umfasst das Leitungssystem 30 Hauptleiterbahnen 38, die sowohl untereinander als auch mit den Rasterbahnen 34 überlappungsfrei sind. Aus Gründen der besseren Übersichtlichkeit sind wieder nur ausgewählte Hauptleiterbahnen 38 mit einem Bezugszeichen versehen.

Die Hauptleiterbahnen 38 verlaufen untereinander kreuzungsfrei.

Zur Versorgung mit elektrischer Energie ist jede der LEDs 26 in einer Richtung quer zur Verlaufsbahn 36 mittels zweier Anschlussbahnen 40 mit der hinsichtlich des Farbtyps zugeordneten Hauptleiterbahn 38 elektrisch verbunden.

Die Anschlussbahnen 40 wiederum sind jeweils mit einem Kontaktabschnitt 42 der zugeordneten LED 26 elektrisch verbunden. Die Kontaktabschnitte 42 erstrecken sich dabei im Wesentlichen entlang der Verlaufsbahn 36.

Es resultiert hieraus, dass jeder der Kreuzungsbereiche 32 durch eine Anschlussbahn 40 und eine Hauptleiterbahn 38 gebildet ist, die jeweils unterschiedlichen Farbtypen zugeordnet sind. Dabei ist die den Kreuzungsbereich 32 bildende Hauptleiterbahn 38 stets benachbart zu einer Hauptleiterbahn 38 angeordnet, mit der die den Kreuzungsbereich 32 bildende Anschlussbahn 40 elektrisch verbunden ist.

Was die Abstände der Rasterbahnen 34 in einer Richtung quer zur Verlaufsbahn 36 betrifft, so liegen zwischen zwei benachbarten Rasterbahnen 34 höchstens N Hauptleiterbahnen 38, wobei die Hauptleiterbahnen 38 jeweils unterschiedlichen Farbtypen zugeordnet sind.

Das ist zum Beispiel in den Ausführungsformen gemäß Figuren 3 und 4 der Fall, bei denen drei bzw. vier Hauptleiterbahnen 38 zwischen benachbarten Rasterbahnen 34 verlaufen.

Alternativ kann das Leitungssystem 30 Hauptleiterbahnen 38 umfassen, wobei zwischen benachbarten Rasterbahnen höchstens 0,5 x N Hauptleiterbahnen 38 vorliegen. Dabei wird 0,5 x N auf die nächsthöhere Ganzzahl aufgerundet. Die Hauptleiterbahnen 38, die in einer Richtung quer zur fiktiven Verlaufsbahn 36 einer Rasterbahn 34 beidseits benachbart sind, sind jeweils unterschiedlichen Farbtypen zugeordnet.

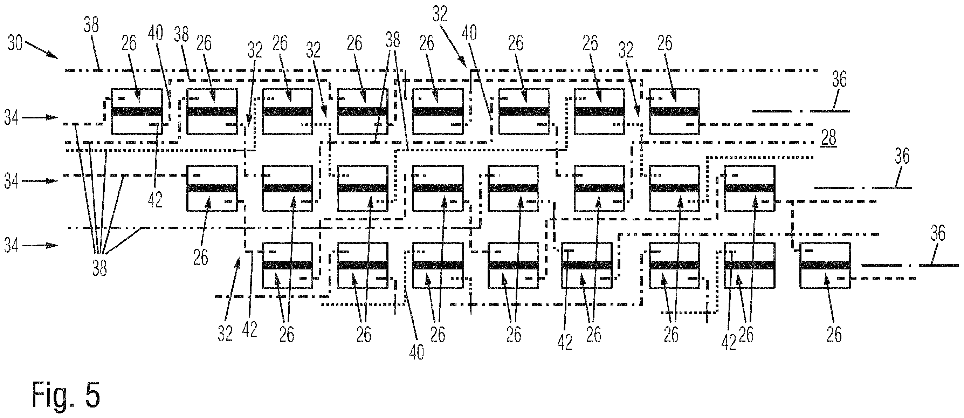

Dies ist im Ausführungsbeispiel gemäß Figur 5 zu sehen. Dort sind N = 4 unterschiedliche Farbtypen vorgesehen, wobei jedoch zwischen benachbarten Rasterbahnen 34 lediglich zwei Hauptleiterbahnen 38 vorliegen.

Was den Abstand zwischen entlang der Verlaufsbahn 36 benachbarten Rasterstellplätzen, also den LEDs 26, angeht, so verlaufen zwischen diesen in allen Ausführungsbeispielen höchstens zwei Anschlussbahnen 40, wobei die Anschlussbahnen 40 jeweils denjenigen Farbtypen zugeordnet sind, die den entlang der Verlaufsbahn 36 angrenzenden LEDs 26 entsprechen.

Wie insbesondere anhand der Figur 2 erkennbar ist, bildet eine Einhüllende der Vielzahl an LEDs 26 einen geschlossenen Polygonzug, der vorliegend ein Sechseck ist. Alternativ könnte es sich auch um einen Kreis oder ein Oval handeln.

Die Optik 20 weist dementsprechend eine Lichteintrittsöffnung 22a auf, die ebenfalls sechseckig ist, also hinsichtlich ihrer Form mit der Einhüllenden korrespondiert. Auch hinsichtlich ihrer Größe entsprechen sich die Lichteintrittsöffnung 22a und die Einhüllende.

Der Optik 20 - z.B. der Kollimationsreflektor 22 - weist ferner eine Lichtaustrittsöffnung 22b auf, die über einen z.B. rohrförmigen Lichtleitabschnitt 22c mit der Lichteintrittsöffnung 22a verbunden ist. Die Innenseite des Lichtleitabschnitts 22c ist reflektierend. Zudem schließt die Lichtaustrittsöffnung 22b einen größeren Flächeninhalt ein als die Lichteintrittsöffnung 22a. Die Optik 20 weitet sich also in der Lichtabstrahlrichtung.

Insgesamt überspannt somit die Optik 20 - z.B. der Kollimationsreflektor - die Gesamtheit der LEDs 26 und ist dazu ausgebildet, das von jeder der LEDs 26 ausgehende Licht zu empfangen und auszugeben.

Um die lichterzeugende Baugruppe 12 und insbesondere die LED-Anordnung 18 vor unerwünschten Umwelteinflüssen zu schützten, also beispielsweise gegen in diese eindringende Partikel, Flüssigkeiten und/oder Gase kann eine Schutzvorrichtung 44 vorgesehen sein.

Bei der Schutzvorrichtung 44 kann es sich gemäß der Variante aus Figur 7a) um ein Schutzglas handeln, das an der Lichtaustrittseite der Optik 20 positioniert ist. Alternativ kann an gleicher Stelle eine Linse oder Streuscheibe vorgesehen sein (vgl. Fig. 7b)).

Auch ist es möglich, eine als Schutzvorrichtung 44 wirkende Linse an der Lichteintrittseite der Optik 20 vorzusehen, wie in Figur 7c) dargestellt ist.

In der Figur 7d) ist eine Variante gezeigt, bei der die Schutzvorrichtung 44 zwei Linsen umfasst. Dabei ist an der Lichteintrittsseite der Optik 20 eine Sammellinse angeordnet sein und an der Lichtaustrittsseite eine achromatische Sammellinse.

Gemäß einer Ausführungsform ist die Optik 20 als ein kegelförmiger oder mehreckförmiger Reflektor, z.B. als ein Reflektor mit hexagonaler Querschnittsfläche ausgebildet, und an der Lichtaustrittsseite der Optik 20 ist die als Diffusor, z.B. als stochastischer oder holografischer Diffusor wirkende Schutzvorrichtung 44 vorgesehen. Der Reflektor kann z.B. auf seiner Lichteintritts- und/oder Außenseite entweder rund bzw. ellipsenförmig oder eckig sein. Die Lichteintritts- und Austrittsseite können unterschiedliche Durchmesser (Umkreise) haben, und so kann beispielsweise ein Reflektor in der Form eines abgeschnittenen Kegels oder einer abgeschnittenen Pyramide entstehen.

## Patentansprüche

1. Lichterzeugende Baugruppe (12) für einen Scheinwerfer (10) zur Beleuchtung einer Film-, Studio-, Bühnen-, Event- und/oder Theaterumgebung, mit
0 einem Träger (24), auf dem eine LED-Anordnung (18) mit einer Vielzahl von LEDs (26) angeordnet ist, wobei die LEDs (26) LEDs von N>2 unterschiedlichen Farbtypen umfassen und von jedem der N Farbtypen eine beliebige Anzahl an LEDs (26) vorgesehen ist, und wobei eine Lötflächenseite einer jeden der LEDs (26) einer Trägervorderseite (28) zugewandt ist, wobei der Träger als einlagige Leiterplatte ausgebildet ist;
einer mit der LED-Anordnung (18) gekoppelten Optik (20), die die Gesamtheit der LEDs (26) überspannt und dazu ausgebildet ist, das von jeder der LEDs (26) ausgehende Licht zu empfangen und zu formen;
0 einem Leitungssystem (30) zur Stromversorgung der LEDs (26), umfassend eine Vielzahl von Leitungen (38, 40) mit N Leitungstypen, **gekennzeichnet dadurch, dass** sich Leitungen (38, 40) unterschiedlichen Leitungstyps in Kreuzungsbereichen (32) kreuzen und die Kreuzungsbereiche (32) in einer vertikalen Draufsicht auf die Trägervorderseite (28) außerhalb einer vertikalen Projektionsfläche der Lötflächenseiten auf die Trägervorderseite (28) liegen.

2. Baugruppe (12) nach Anspruch 1, wobei die sich kreuzenden Leitungen (38, 40) in einer Richtung vertikal zu einer Trägervorderseite (28) übereinander verlaufen und eine der sich kreuzenden Leitungen (38, 40) als Bondbrücke ausgebildet ist, die die jeweils andere sich kreuzende Leitung (38, 40) überspannt.

3. Baugruppe (12) nach einem der vorhergehenden Ansprüche, wobei alle LEDs (26) gemäß einem regelmäßigen Raster auf der Trägervorderseite (28) angeordnet sind, wonach:
0 auf der Trägervorderseite (28) eine Vielzahl von zueinander überlappungsfrei und in einem Querabstand angeordneten Rasterbahnen (34) vorgesehen ist;
0 jede Rasterbahn (34) eine Vielzahl von Rasterstellplätzen umfasst, auf der jeweils eine LED (26) positionierbar ist, wobei die Rasterstellplätze einzeln hintereinander entlang einer fiktiven Verlaufsbahn (36) vom Rasterbahneingang zum Rasterbahnausgang angeordnet sind; und
0 in jeder von mindestens 90% aller Rasterbahnen (34) mindestens eine LED (26) von jedem der N unterschiedlichen Farbtypen vorgesehen ist, wobei die LEDs (26) innerhalb der Rasterbahnen (34) in beliebiger Reihenfolge angeordnet sind.

4. Baugruppe (12) nach einem der vorhergehenden Ansprüche, wobei die Optik (20) als ein kegelförmiger oder mehreckförmiger Reflektor, z.B. als ein Reflektor mit hexagonaler Querschnittsfläche ausgebildet ist.

5. Baugruppe (12) nach einem der vorhergehenden Ansprüche, weiter umfassend eine als Diffusor, z.B. als stochastischer oder holografischer Diffusor wirkende Schutzvorrichtung (44), die an einer Lichtaustrittsseite der Optik (20) vorgesehen ist.

6. Baugruppe (12) nach einem der vorhergehenden Ansprüche, wobei die Optik (20) eine singuläre Kollimationsoptik ist.

7. Baugruppe (12) nach einem der vorhergehenden Ansprüche, wobei die Optik (20) eine Lichteintrittsöffnung (22a) sowie eine Lichtaustrittsöffnung (22b) aufweist, die über einen Lichtleitabschnitt (22c) verbunden sind, wobei eine Innenseite des Lichtleitabschnitts (22c) reflektierend ist.

8. Baugruppe (12) nach Anspruch 7, wobei in einer Aufsicht auf die Trägervorderseite (28) eine Einhüllende der Vielzahl von LEDs (26) ein geschlossener Polygonzug, ein Kreis oder ein Oval ist, und ein Randbereich der Lichteintrittsöffnung (22a) hinsichtlich seiner Form und seiner Größe der Einhüllenden entspricht.

9. Scheinwerfer (10) mit einer lichterzeugenden Baugruppe (12) nach einem der vorhergehenden Ansprüche.

## Claims

1. Light-producing assembly (12) for a spotlight (10) for illuminating a film, studio, stage, event and/or theatre environment, comprising
∘ a carrier (24), on which an LED arrangement (18) having a multiplicity of LEDs (26) is arranged, the LEDs (26) comprising LEDs with N >2 different colour types and any desired number of LEDs (26) being provided for each of the N colour types, and with a solder side of each LED (26) facing a carrier front side (28), the carrier being in the form of a single layer printed circuit board;
∘ an optical unit (20) coupled to the LED arrangement (18), said optical unit spanning the totality of the LEDs (26) and being designed to receive and shape the light emanating from each LED (26);
∘ a line system (30) for supplying power to the LEDs (26), comprising a multiplicity of lines (38, 40) with N line types, **characterized in that** lines (38, 40) of different line types cross in crossing regions (32) and the crossing regions (32) lie outside of a vertical projection surface of the solder sides on the carrier front side (28) in a vertical plan view of the carrier front side.

2. Assembly (12) according to Claim 1, wherein the crossing lines (38, 40) extend one above the other in a direction vertical to a carrier front side (28) and one of the crossing lines (38, 40) is in the form of a bonding bridge, which spans the respective other crossing line (38, 40).

3. Assembly (12) according to either of the preceding claims, wherein all LEDs (26) are arranged in accordance with a regular grid on the carrier front side (28), according to which:
∘ a multiplicity of grid tracks (34) that do not overlap one another and that are arranged at a transverse distance from one another are provided on the carrier front side (28);
∘ each grid track (34) comprises a multiplicity of grid holding areas, on each of which one LED (26) is positionable, the grid holding areas being arranged individually in succession along a fictitious trajectory (36) from the grid track entrance to the grid track exit; and
∘ at least one LED (26) of each of the N different colour types is provided in each of at least 90% of all grid tracks (34), with the LEDs (26) being arranged in any desired sequence within the grid tracks (34).

4. Assembly (12) according to any one of the preceding claims, wherein the optical unit (20) is embodied as a conical or polygonal reflector, for example as a reflector with a hexagonal cross-sectional area.

5. Assembly (12) according to any one of the preceding claims, further comprising a protective apparatus (44) acting as a diffuser, for example as a stochastic a holographic diffuser, provided at a light emergence side of the optical unit (20).

6. Assembly (12) according to any one of the preceding claims, wherein the optical unit (20) is a singular collimation optical unit.

7. Assembly (12) according to any one of the preceding claims, wherein the optical unit (20) has a light entry opening (22a) and a light emergence opening (22b) which are interconnected by way of a light-guiding portion (22c), an inner side of the light-guiding portion (22c) being reflective.

8. Assembly (12) according to Claim 7, wherein, in a plan view of the carrier front side (28), an envelope of the multiplicity of LEDs (26) is a closed polygonal chain, a circle or an oval, and an edge region of the light entry opening (22a) corresponds in terms of its shape and size to the envelope.

9. Spotlight (10) comprising a light-producing assembly (12) according to any one of the preceding claims.

## Revendications

1. Sous-ensemble (12) générateur de lumière pour un projecteur (10) servant à l'éclairage d'un environnement de film, de studio, de scène, d'événement et/ou de théâtre, comprenant
ο un support (24), sur lequel est disposé un arrangement de LED (18) comprenant une pluralité de LED (26), les LED (26) incluant des LED de N > 2 types de couleur différents et un nombre quelconque de LED (26) de chacun des N types de couleur étant présent, et un côté surface de soudage de chacune des LED (26) faisant face à un côté avant de support (28), le support étant réalisé sous la forme d'un circuit imprimé monocouche ; une optique (20) accouplée à l'arrangement de LED (18), qui recouvre l'ensemble des LED (26) et qui est configurée pour recevoir et mettre en forme la lumière émise par chacune des LED (26) ;
ο un système de lignes (30) destiné à l'alimentation électrique des LED (26), comportant une pluralité de lignes (38, 40) avec N types de lignes,
**caractérisé en ce que**
les lignes (38, 40) de différents types de lignes se croisent dans des zones d'intersection (32) et les zones d'intersection (32), en une vue de dessus verticale, se trouvent sur le côté avant de support (28) à l'extérieur d'une surface de projection verticale des côtés surface de soudage sur le côté avant de support (28).

2. Sous-ensemble (12) selon la revendication 1, les lignes (38, 40) qui se croisent en suivant un tracé les unes au-dessus des autres dans une direction verticale par rapport à un côté avant de support (28) et l'une des lignes (38, 40) qui se croisent étant réalisée sous la forme d'un cavalier de connexion qui enjambe respectivement les autres lignes (38, 40) qui se croisent.

3. Sous-ensemble (12) selon l'une des revendications précédentes, toutes les LED (26) étant disposées sur le côté avant de support (28) conformément à une grille régulière, moyennant quoi :
o une pluralité de bandes de grille (34) sans chevauchement mutuel et disposées à un écart transversal étant présentes sur le côté avant de support (28) ;
o chaque bande de grille (34) comporte une pluralité d'emplacements de grille sur lesquels peut respectivement être positionnée une LED (26), les emplacements de grille étant disposés individuellement les uns derrière les autres le long d'une bande de tracé fictive (36) de l'entrée de la bande de grille à la sortie de la bande de grille ; et
o dans chacune d'au moins 90 % de toutes les bandes de grille (34) se trouve au moins une LED (26) de chacun des N différents types de couleur, les LED (26) au sein des bandes de grille (34) étant disposées dans un ordre quelconque.

4. Sous-ensemble (12) selon l'une des revendications précédentes, l'optique (20) étant réalisée sous la forme d'un réflecteur conique ou polygonal, par exemple sous la forme d'un réflecteur ayant une surface de section transversale hexagonale.

5. Sous-ensemble (12) selon l'une des revendications précédentes, comprenant en outre un dispositif de protection (44) agissant en tant que diffuseur, par exemple en tant que diffuseur stochastique ou holographique, lequel se trouve au niveau d'un côté de sortie de lumière de l'optique (20).

6. Sous-ensemble (12) selon l'une des revendications précédentes, l'optique (20) étant une optique de collimation singulière.

7. Sous-ensemble (12) selon l'une des revendications précédentes, l'optique (20) possédant une ouverture d'entrée de lumière (22a) ainsi qu'une ouverture de sortie de lumière (22b), lesquelles sont reliées par le biais d'une portion de conduction de lumière (22c), un côté intérieur de la portion de conduction de lumière (22c) étant réfléchissant.

8. Sous-ensemble (12) selon la revendication 7, dans une vue sur le côté avant de support (28), une enveloppe de la pluralité de LED (26) est un tracé polygonal fermé, un cercle ou un ovale, et une zone de bordure de l'ouverture d'entrée de lumière (22a) correspond à l'enveloppe du point de vue de sa forme et de sa taille.

9. Projecteur (10) comprenant un sous-ensemble (12) générateur de lumière selon l'une des revendications précédentes.
